(19) **Europäisches Patentamt**

**European Patent Office**

**Office européen des brevets**

(11) **EP 1 464 098 B1**

(12) **EUROPÄISCHE PATENTSCHRIFT**

(45) Veröffentlichungstag und Bekanntmachung des Hinweises auf die Patenterteilung:
**30.08.2006 Patentblatt 2006/35**

(51) Int Cl.:
*H01S 5/12* (2006.01)     *G02B 5/18* (2006.01)

(21) Anmeldenummer: 03729213.3

(22) Anmeldetag: **08.01.2003**

(86) Internationale Anmeldenummer:
**PCT/DE2003/000072**

(87) Internationale Veröffentlichungsnummer:
**WO 2003/058685 (17.07.2003 Gazette 2003/29)**

(54) **VERFAHREN ZUR HERSTELLUNG EINES BRAGGSCHEN GITTERS IN EINER HALBLEITERSCHICHTENFOLGE MITTELS ÄTZEN UND HALBLEITERBAUELEMENT**

METHOD FOR THE PRODUCTION OF A BRAGG GRATING IN A SEMICONDUCTOR LAYER SEQUENCE BY ETCHING AND SEMICONDUCTOR ELEMENT

PROCEDE DE FABRICATION D'UN RESEAU DE BRAGG DANS UNE SEQUENCE DE COUCHES DE SEMI-CONDUCTEUR A L'AIDE DE LA GRAVURE, ET ELEMENT SEMI-CONDUCTEUR AINSI OBTENU

(84) Benannte Vertragsstaaten:
**AT BE BG CH CY CZ DE DK EE ES FI FR GB GR HU IE IT LI LU MC NL PT SE SI SK TR**

(30) Priorität: **08.01.2002 DE 10200360**

(43) Veröffentlichungstag der Anmeldung:
**06.10.2004 Patentblatt 2004/41**

(73) Patentinhaber: **Forschungsverbund Berlin e.V. 12489 Berlin (DE)**

(72) Erfinder:
• **BRAUN, Matthias 10439 Berlin (DE)**
• **ERBERT, Götz 12555 Berlin (DE)**
• **WENZEL, Hans 12355 Berlin (DE)**

(74) Vertreter: **Hengelhaupt, Jürgen et al Anwaltskanzlei Gulde Hengelhaupt Ziebig & Schneider Wallstrasse 58/59 10179 Berlin (DE)**

(56) Entgegenhaltungen:
**EP-A- 0 444 350          WO-A-01/69735**

• **GOLDSTEIN L ET AL: "OPTOELECTRONIC DEVICES BY GAS SOURCE MOLECULAR BEAM EPITAXY" JOURNAL OF CRYSTAL GROWTH, NORTH-HOLLAND PUBLISHING CO. AMSTERDAM, NL, Bd. 120, Nr. 1 / 4, 2. Mai 1992 (1992-05-02), Seiten 157-161, XP000276692 ISSN: 0022-0248**

**Beschreibung**

Die Erfindung betrifft ein Verfahren zur Herstellung eines Braggschen Gitters in einer Halbleiterschichtenfolge mittels Ätzen gemäß dem Oberbegriff des Anspruchs 1 und ein Halbleiter-Bauelement mit Braggschem Gitter gemäß Anspruch 5.

Üblicherweise erfolgt die Herstellung von Braggschen Gittern in Halbleitern durch Erzeugen einer Maskierungsschicht mit der entsprechenden Gitterperiode und nachfolgendem Übertragen der Struktur in die darunter liegenden Halbleiterschichten mittels geeigneten Ätzverfahren.

Die Herstellung dieser periodischen Strukturen, auch Korrugationen genannt, kann durch trocken- oder nasschemisches Ätzen geschehen.

Die Maskierungsschicht wird üblicherweise durch einen Photolack gebildet, der durch Belichtung und nachfolgendes Entwickeln entsprechend strukturiert wurde. Zur Belichtung der Lackstrukturen wird die Elektronenstrahlbelichtung oder die holografische Belichtung eingesetzt.

Bei der holografischen Belichtung wird durch Beugung von kohärentem (Laser-) Licht an einem Raumfrequenzfilter eine Kugelwelle erzeugt. Durch Überlagerung zweier Teilstrahlen dieser Kugelwelle kommt das Licht zur Interferenz. Durch geeignete Wahl der Laserwellenlänge und Anordnung eines Wafers im Strahlengang entsteht auf dessen Waferoberfläche ein Interferenzmuster des Lichts mit der gewünschten Periodenlänge. Die Periodenlänge lässt sich also relativ leicht durch den Neigungswinkel des Wafers zum Strahlengang festlegen.

Um Braggsche Gitter für Laserwellenlängen im nähen infraroten, sichtbaren und ultravioletten Bereich herzustellen, wird kurzwelliges Laserlicht für die Belichtung benötigt. Die für diese Zwecke auf dem Markt verfügbaren Laser mit ausreichender Strahlqualität besitzen eine kürzeste Wellenlänge von typischerweise 270nm. Damit lässt sich eine minimale Gitterperiode von ca. 135nm erzeugen. Mit einem typischen effektiven Brechungsindex von ca. 3,3 (für III-V Halbleiter) lassen sich also Braggsche Gitter 1. Ordnung für eine Wellenlänge von minimal 900nm herstellen. Für kürzere Laserwellenlängen müssen also Braggsche Gitter höherer Ordnung verwendet werden. Im Gegensatz zu Gittern 1. Ordnung wird für einen maximalen Koppelkoeffizienten bei Gittern 2. und höherer gerader Ordnung nicht das Tastverhältnis von 1/2 benötigt, sondern es wird ein Tastverhältnis von 1/4 bzw. 3/4 erforderlich.

Die Herstellung eines Braggschen Gitters in einer Halbleiterschicht $S_1$ (Dicke $d_1$ und Brechungsindex $n_1$) mit deutlich von 1/2 verschiedenem Tastverhältnis wird nach dem Stand der Technik mittels einer entsprechenden Struktur der Maskierungsschicht hergestellt, die dann durch ein geeignetes Ätzverfahren in die darunter liegende Halbleiterschicht übertragen wird. Durch Überwachsen mit einer zweiten Schicht eines geeigneten Materials mit einem zum Material der ersten Schicht unterschiedlichem Brechungsindex ergibt sich in lateraler Richtung die gewünschte periodische Änderung des Brechungsindex.

In der Praxis zeigt sich aber gerade für sehr kleine Gitterperioden im Bereich von unter ca. 350 nm, dass die zur Herstellung eines Braggschen Gitters mit einem deutlich von 1/2 verschiedenen Tastverhältnisses entsprechenden Maskierungsschichten nur schwer realisierbar sind. Dies liegt daran, dass sich die notwendigen asymmetrischen Maskierungsschichten erfahrungsgemäß nur schwer reproduzierbar herstellen lassen, was durch geringe Kontrastverhältnisse der beiden interferierenden Teilstrahlen zusätzlich erschwert wird.

In der Veröffentlichung "1.3-$\mu$m Distributed Feedback Laser Diode with a Grating Accurately Controlled by a New Fabrication Technique" von A. Takemoto u.a., Journal of Lightwave Technology, Vol. 7, Nr.12, S. 2072-2076 (1989) werden zwei Methoden zur Herstellung von Braggschen Gittern beschrieben.

Bei der in der Publikation als "konventionell" beschriebenen Struktur wird das Braggsche Gitter in eine Halbleiterschicht geätzt, ohne diese durchzuätzen, wobei der Kopplungskoeffizient im wesentlichen durch die Ätztiefe bestimmt wird.

Bei der in der Publikation als "neu" bezeichneten Struktur wird das Braggsche Gitter durch komplettes Durchätzen einer Halbleiterschicht erzeugt, wodurch der Kopplungskoeffizient nicht mehr von der Ätztiefe bestimmt wird, sondern durch die Dicke der Halbleiterschichten, welche sehr genau eingestellt werden können.

Beide Methoden erlauben keine genaue Kontrolle des Tastverhältnisses des Braggschen Gitters.

In der Veröffentlichung "Electron beam defined surface gratings in AlGaAs with precisely controlled duty cylce using a multiple exposure technique" von N. Eriksson u.a, Journal of Vacuum Science and Technology B, Vol. 41, Nr. 1, S. 184.186 (1996) werden verschiedene Methoden beschrieben, wie das Tastverhältnis ("duty cycle") von Braggschen Gittern mit Hilfe der Elektronenstrahlbelichtung gezielt eingestellt werden kann.

Dies wird durch eine Veränderung der Parameter der Elektronenstrahlbelichtung erreicht. Die Elektronenstrahlbelichtung ist jedoch wesentlich langwieriger und aufwendiger als die holografische Belichtung. Ein weiterer Nachteil ist, dass die Gitterperioden nur in Stufen einstellbar sind.

Aus WO 01/69735 ist ein Laser mit einem gewinngekoppelten Braggschen Gitter und ein Verfahren zu seiner Herstellung bekannt. Bei einem gewinngekoppelten Bragg-Gitter wird durch eine Korrugation der aktiven Schichten eine periodische Änderung des Gewinnkoeffizienten erreicht, womit jedoch eine unerwünschte periodische Änderung der Brechzahl verbunden ist. Diese soll hier durch Wahl der Zusammensetzung der Barriereschichten vermieden werden.

Über die Herstellung eines bestimmten Tastverhältnisses für Gitter höherer Ordnung ist hier keine Aussage getroffen.

EP 0 444 350 A2 beschreibt ein Verfahren, mit dem die Form einer korrugierten InGaAsP-Schicht beim Überwachsen stabilisiert wird. Es wird ein Tastverhältnis der strukturierten InGaAsP-Schicht von 0,5 angestrebt.

In Goldstein et al., Optoelectronic Devices by Gas Source Molecular Beam Epitaxy, Journal of Crystal Growth. Bd. 120, Nr. 1/4 (02.Mai 1992), Seiten 157-161 wird eine spezielle Bragg-Gitterstruktur, bestehend aus InGaAsP und InP und ein Verfahren zur Herstellung von DFB-Lasern beschrieben. Es wir ein Bragg-Gitter erster Ordnung hergestellt.

GB 2 292 011 A beschreibt Bauelemente mit Bragg-Gittern und ein Verfahren zu deren Herstellung, nach dem das Bragg-Gitter aus einer Schichtenfolge InGaAs/InP aufgebaut ist ("superlattice layer"). Auf ein Tastverhältnis wird nicht eingegangen.

US 2 020 072 beschreibt ebenfalls ein Verfahren zur Herstellung eines Braggschen Gitters. Ziel ist die reproduzierbare Einstellung des Koppelkoeffizienten des Gitters. Dazu wird die Gitterschicht bis in die Unterlage durchgeätzt und mit einem Material mit einer Brechzahl überwachsen, welche identisch zur der der Unterlage ist. Auf die Einstellung eines bestimmten Tastverhältnisses wird nicht eingegangen.

Aufgabe der Erfindung ist es, ein Verfahren und ein Bauelement aufzuzeigen, mit dem Braggsche Gitter mit Tastverhältnissen von 1/4 und 3/4 mittels holografischer Belichtung hergestellt werden können, ohne dass die Maskierungsschicht im gleichen Tastverhältnis strukturiert ist wie das Braggsche Gitter, und mit dem eine genaue Einstellung und Kontrolle des Tastverhältnisses des Braggschen Gitters ohne die Verwendung bzw. Veränderung einer Elektronenstrahlbelichtung gewährleistet wird.

Diese Aufgabe wird durch die Merkmale des Verfahrens gemäß Anspruch 1 und durch ein Halbleiter-Bauelement mit den Merkmalen nach Anspruch 4 gelöst.

Das Verfahren zur Herstellung eines Braggschen Gitters in einer Halbleiterschichtenfolge eines Halbleiterkörpers mit den zugehörigen Schichtdicken und Brechungsindices mittels Ätzen ist dadurch gekennzeichnet, dass die zusätzliche eingebrachte Schicht mit einem Winkel $\alpha$, der sich aus dem Ätzprozess und der Kristallorientierung der zu ätzenden Materialien bestimmt, so geätzt wird, dass sich in der zusätzlich eingebrachten Schicht ein Tastverhältnis $\Lambda_1/\Lambda$ von 1/4 oder 3/4 ergibt, wobei die Dicke ($d_{24}$) der über der zusätzlichen Halbleiterschicht liegenden Schicht aus dem gewünschten Tastverhältnis nach der Beziehung

$$\frac{\Lambda_1}{\Lambda} = \frac{1}{2} + \frac{2(d_{24}+\frac{d_{23}}{2})}{\Lambda \tan \alpha}$$

ermittelt wird, in der die Periode der Brechzahländerung A sich aus der Beziehung

$$\lambda = 2n\Lambda / m$$

ergibt, in der
$\lambda$ die Wellenlänge des Lichts ist, $n$ die mittlere Brechzahl des Materials der Schichtenfolge des Halbleiterkörpers und m die Ordnung des Braggschen Gitters,
und nach Entfernen der Maskierungsschicht abschließend eine Halbleiterschicht mit einem Brechungsindex, welcher den Brechungsindices der die zusätzliche Schicht umgebenden Schichten entspricht, aufgebracht wird.

Das Halbleiter-Bauelement mit geätzter Braggscher Gitterstruktur nach der Erfindung ist dadurch gekennzeichnet, dass die Gitterstruktur des Braggschen Gitters mit einem Winkel $\alpha$ bis mindestens einschließlich der zusätzlichen Halbleiterschicht oder zusätzlichen Halbleiterschichten so herausgeätzt ist, dass die zusätzlich eingebrachte Schicht ein Tastverhältnis $\Lambda_1/\Lambda$ von 1/4 oder 3/4 einnimmt, wobei sich die Dicke ($d_{24}$) der über der zusätzlichen Halbleiterschicht (23) liegenden Schicht (24) aus dem gewünschten Tastverhältnis nach der Beziehung

$$\frac{\Lambda_1}{\Lambda} = \frac{1}{2} + \frac{2(d_{24}+\frac{d_{23}}{2})}{\Lambda \tan \alpha}$$

ergibt, in der die Periode der Brechzahländerung A aus der Beziehung

$$\lambda = 2n\Lambda / m$$

ermittelt ist, in der

$\lambda$ die Wellenlänge des Lichts ist, $n$ die mittlere Brechzahl des Materials der Schichtenfolge des Halbleiterkörpers und m die Ordnung des Braggschen Gitters.

In bevorzugter Weise ist die Gitterstruktur der oberen Wellenleiterschichten aus AlGaAs, InGaP, GaAsP, InGaP in einem Halbleiterkörper mit einer Maskierungsschicht in vertikaler Folge ausgebildet.

Zur Herstellung von Braggschen Gittern wird eine holografische Belichtung verwendet, und das Tastverhältnis wird durch eine geeignete Anordnung von Halbleiterschichten eingestellt.

Zweckmäßige Ausführungsformen der Erfindung sind in den Unteransprüchen beschrieben.

Die Erfindung wird in einem allgemeinen Ausführungsbeispiel des Verfahrens nach der Erfindung und in einer Anwendung bei einer Laserstruktur näher erläutert. In der zugehörigen Zeichnung zeigen:

Fig. 1: die schematische Darstellung eines strukturierten Halbleiterkörpers mit einer Maskierungsschicht zur Erläuterung des Tastverhältnisses,

Fig. 2a bis 2c die schematische Darstellung der Herstellung eines Braggschen Gitters nach dem bekannten Stand der Technik ,

Fig. 3a bis 3c: die schematische Darstellung der Herstellung eines Braggschen Gitters nach der Erfindung und

Fig. 4: die schematische Darstellung des Schichtaufbaus einer vertikalen Laserstruktur mit Gitterschichten, hergestellt nach dem Verfahren nach der Erfindung.

Es ist bekannt, dass ein Material, dessen Brechzahl sich entlang einer Raumrichtung periodisch ändert (sogenanntes Braggsches Gitter), als wellenlängenselektiver Reflektor wirkt: Lichtwellen, die sich in Richtung der periodischen Änderung ausbreiten und deren Wellenlängen $\lambda$ die Beziehung

$$\lambda = 2n\Lambda / m \qquad\qquad (1)$$

erfüllen, wobei $n$ die mittlere Brechzahl des Materials, $\Lambda$ die Periode der Brechzahländerung und $m$ die sogenannte Ordnung des Braggschen Gitters ist ($m$=1,2,3...).

Die Stärke der Wechselwirkung des Braggschen Gitters mit den Lichtwellen wird durch den sogenannten Kopplungskoeffizienten $\kappa$ beschrieben. Für sprunghafte Änderungen der Brechzahl (d.h. für eine Schichtenfolge $n_1 n_2 n_1 n_2 n_1...$) kann er durch die Beziehung

$$\kappa = \frac{2 \cdot \Delta n \cdot \sin(m \cdot \pi \cdot \Lambda_1 / \Lambda)}{m \cdot \lambda} \qquad\qquad (2)$$

berechnet werden, solange $\Delta n/n$ nicht zu groß ist (typischerweise kleiner 0,01). Dabei ist $\Delta n = n_1 - n_2$ die Differenz der Brechzahlen und $\Lambda_1$ die Dicke der Schicht mit der Brechzahl $n_1$.

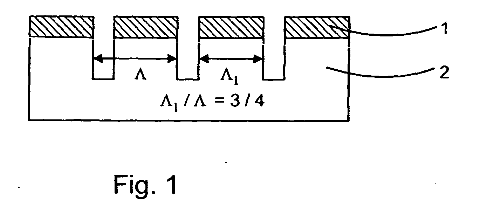

Aus der Gleichung (2) geht hervor, dass die Größe des Kopplungskoeffizienten proportional zur Differenz der Brechzahlen ist und vom Verhältnis $\Lambda_1/\Lambda$, dem sogenannten Tastverhältnis des Braggschen Gitters, abhängt (Fig. 1).

In Gleichung (2) können die Brechzahlen auch einen Imaginärteil besitzen. Der Imaginärteil der Brechzahl beschreibt eine Dämpfung oder Verstärkung der Lichtwelle. Falls die Imaginärteile der Brechzahlen der Schichten unterschiedlich sind, erhält man eine periodische Änderung der Dämpfung oder der Verstärkung, und der Kopplungskoeffizient erhält ebenfalls einen Imaginärteil.

Falls das Braggsche Gitter im wesentlichen durch die periodische Änderung des Realteils der Brechzahl zustande kommt, spricht man von Indexkopplung, andernfalls von Verlust- oder Verstärkungskopplung.

In Verbindungshalbleiterbauelementen kann eine periodische Änderung der Brechzahl auf zweierlei Art erreicht werden:

Erstens, durch Abscheidung vieler Paare von zwei Verbindungshalbleitern mit unterschiedlicher Brechzahl, z.B. mit metallorganischer Gasphasenepitaxie (MOVPE) oder Molekularstrahlepitaxie (MBE). Die Ausbreitung und Reflexion der Lichtwellen erfolgt senkrecht zu den Schichten. Dieses Wirkungsprinzip wird z.B. in oberflächenemittierenden Halbleiterlasern (sogenannten VCSELn) ausgenutzt.

Zweitens, in dem in die Oberfläche einer Verbindungshalbleiterschicht eine Korrugation geätzt wird, die in einer Raumrichtung eine periodische Struktur aufweist. Wird auf die so strukturierte Oberfläche ein Verbindungshalbleiter mit einer anderen Brechzahl abgeschieden, z.B. mit MOVPE oder MBE, so ändert sich die effektive Brechzahl von Lichtwellen, welche sich parallel zu den Verbindungshalbleiterschichten, aber senkrecht zu der periodischen Struktur ausbreiten, ebenfalls periodisch und man erhält wiederum ein Braggsches Gitter. Dieses Wirkungsprinzip wird z.B. in kantenemittierenden Halbleiterlasern mit verteilter Rückkopplung und Braggschen Reflektoren (sogenannten DFB- und DBR-Lasern) ausgenutzt. Die Gleichungen (1) und (2) bleiben näherungsweise weiter gültig, wobei die Brechzahl $n$ durch eine effektive Brechzahl $n_{eff}$ ersetzt werden muss. Die Differenz der effektiven Brechzahlen $\Delta n_{eff} = n_{eff,1} - n_{eff,2}$ wird jetzt nicht nur durch die Differenz der Brechzahlen der beteiligten Verbindungshalbleiter bestimmt, sondern im allgemeinen auch durch die Tiefe der Korrugation und durch die Stärke der Intensität des Lichtfeldes im Bereich der Korrugation. Die Ausbreitung der Lichtwellen parallel zu den Schichten wird dadurch erzwungen, dass eine Schichtenfolge von Verbindungshalbleitern so abgeschieden wird, dass ein sogenannter Wellenleiter gebildet wird, bei dem die Brechzahl der zentralen Schichten (sogenannte Wellenleiterschichten) größer ist als die diese Schichten begrenzenden Schichten (sogenannte Mantelschichten). In einem kantenemittierenden Halbleiterlaser bildet die optisch aktive Schicht allein oder in Kombination mit angrenzenden Schichten den Wellenleiter.

Die vorliegende Patentanmeldung bezieht sich auf die unter zweitens beschriebene Art von Verbindungshalbleiterbauelementen. Aufgrund der Herstellung des Braggschen Gitters mittels Ätzverfahren ist es schwierig, einen definierten Kopplungskoeffizienten nach Gleichung (2) zu erhalten. Insbesondere die Einstellung des Tastverhältnisses $\Lambda_1/\Lambda$ bereitet Probleme. Auf der anderen Seite muss aber z.B. bei Braggschen Gittern 2. Ordnung ($m = 2$) das Tastverhältnis $\Lambda_1/\Lambda$ möglichst genau 1/4 oder 3/4 sein, um nach Gleichung (2) einen maximalen Kopplungskoeffizienten zu erhalten.

Braggsche Gitter 2. Ordnung haben den Vorteil, dass ihre Gitterperiode $\Lambda$ nach Gleichung (1) zweimal so groß wie die bei einem Braggschen Gitter 1. Ordnung ist und sich somit wesentlich einfacher herstellen lassen. Z. B. beträgt bei einer Wellenlänge $\lambda = 1\ \mu$m die Periode eines Gitter 1. Ordnung ungefähr $\Lambda = 150$ nm, während die Periode eines Gitters 2. Ordnung $\Lambda = 300$ nm beträgt.

Die vorliegende Patentanmeldung beschreibt ein Verfahren zur Einstellung einer definierten Differenz der effektiven Brechzahlen $\Delta n_{eff}$ und eines definierten Tastverhältnisses $\Lambda_1/\Lambda$.

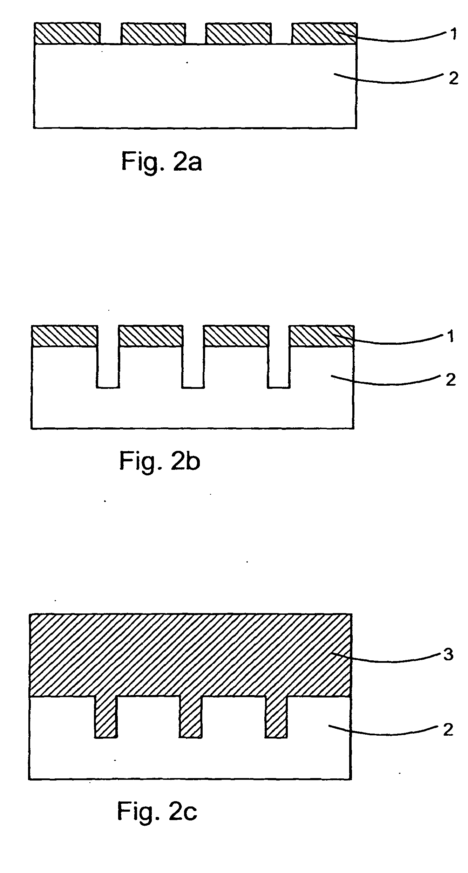

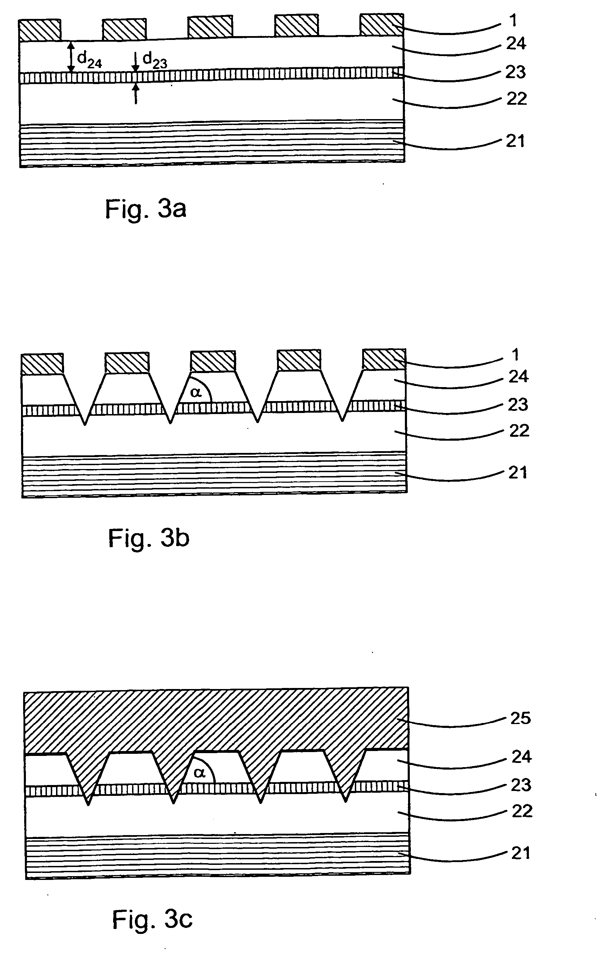

Die Fig. 2 und 3 zeigen in schematischer Darstellung die Unterschiede des Schichtaufbaus bei der Herstellung eines Braggschen Gitters nach dem bekannten Stand der Technik (Fig. 2a bis 2c) und nach der Erfindung (Fig. 3a bis 3c).

Entsprechend den Fig. 2a bis 2c wird nach dem Stand der Technik in einen Halbleiterkörper 2 mit einer strukturierten Maskierungsschicht 1 (Fig. 2a) mittels Ätzen eine Gitterstruktur hergestellt (Fig. 2b), die mit einer Halbleiterschicht 3 überwachsen wird (Fig. 2c).

Nach dem erfindungsgemäßen Verfahren wird gemäß der Darstellung in der Fig. 3a in einen Halbleiterkörper mit den Halbleiterschichten 21, 22, 24 und der strukturierten Maskierungsschicht 1, in die Schicht, in der ein Braggsches Gitter hergestellt werden soll, eine zusätzliche Halbleiterschicht 23 eingebracht. Dies erfolgt im Rahmen der üblichen Herstellung der Vertikalstruktur mittels eines Epitaxieverfahrens.

Diese zusätzliche Schicht 23 besitzt im allgemeinsten Fall einen von den angrenzenden Schichten 24 und 22 unterschiedlichen Brechungsindex $n_{23}$.

$$n_{23} \neq n_{24} \approx n_{22} \tag{3}$$

Der Brechungsindexsprung wird so gewählt, dass die Koppelkonstante des Gitters den angestrebten Wert erreicht.

Anschließend wird dass Braggsche Gitter geätzt (Fig. 3b).

Dazu wird der die Maskierungsschicht 1 bildende Photolack mit einem Tastverhältnis von etwa 1/2 strukturiert. Anschließend werden die darunter liegenden Schichten 24, 23, 22 trocken- oder nasschemisch geätzt. Die Dicke $d_{24}$ der Schicht 24 wird nun so gewählt, dass die Schichten 22, 23 und 24 in Verbindung mit dem Winkel $\alpha$ so geätzt werden, dass diese Schicht 23 -im gewünschten Tastverhältnis strukturiert wird. Der Winkel $\alpha$ wird durch den Ätzprozess in Verbindung mit der Kristallorientierung bestimmt.

Das Tastverhältnis für die geätzte Struktur ergibt sich aus dem Winkel $\alpha$, der Dicke $d_{24}$ der Schicht 24 und der Dicke $d_{23}$ der Schicht 23 näherungsweise wie folgt:

$$\frac{\Lambda_1}{\Lambda} = \frac{1}{2} + \frac{2(d_{24} + \frac{d_{23}}{2})}{\Lambda \tan \alpha} \tag{5}$$

Das Tastverhältnis lässt sich also für ein gegebenes Material im wesentlichen durch die Dicke $d_{24}$ der Schicht 24, einstellen. Anschließend wird eine Verbindungshalbleiterschicht 25 abgeschieden (Fig. 3c), für deren Brechzahl gilt

$$n_{25} \approx n_{22} \approx n_{24} \tag{6}$$

Es kann sich um den gleichen Verbindungshalbleiter wie den der Schichten 24 und 22 handeln, aber auch einen anderen, solange nur die Beziehung (6) erfüllt ist. Das Überwachsen mit dem gleichen Verbindungshalbleiter ist für ein gutes Anwachsen bzw. eine gute Schichtmorphologie der 2. Epitaxie von Vorteil.

Die Größe des Kopplungskoeffizienten wird im wesentlichen durch die Differenz $n_{25}-n_{22}$, die Dicke $d_{23}$ der Schicht 23 und deren Abstand von der Mitte des Wellenleiters bestimmt.

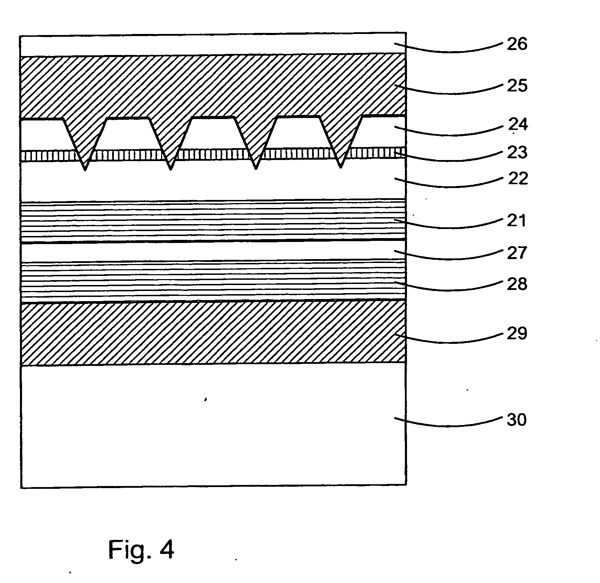

In der Fig. 4 ist als eine Ausführungsform des Verfahrens der vertikale Schichtaufbau einer Laserstruktur für eine Wellenlänge von 860nm schematisch dargestellt.

Die Gitterschichten 21 bis 24 sind analog zu den Schichten in der Fig. 3 obere Wellenleiterschichten.

Zur Herstellung eines entsprechenden Braggschen Gitters für diese Wellenlänge wäre ein Gitter erster Ordnung mit ca. A = 130nm Periode notwendig. Diese Wellenlänge kann mit keinem der bekannten und verfügbaren He-Cd, Argon-Ionen oder Neodym-dotierte Festkörper-Laser holografisch erzeugt werden. Daher muss ein Gitter höherer Ordnung verwendet werden.

Ein Gitter 2. Ordnung müsste also eine Gitterperiode von A = 260nm aufweisen, das sich mit einem der herkömmlichen Laser herstellen lässt.

Gemäß der Vertikalstruktur des Lasers soll das Gitter in eine InGaP-Schicht ($n_{22} = n_{24}$: 3,27) eingebracht werden. Um einen möglichst großen Koppelkoeffizienten zu erhalten, muss das Gitter mit einem Tastverhältnis von 1/4 bzw. 3/4 strukturiert werden. Um dies erfindungsgemäß durch Ätzung über eine Maskierungsschicht mit Tastverhältnis von 1/2 zu erreichen, wird eine zusätzliche Schicht 23 aus GaAsP ($n_{23}$: 3,52) mit der Dicke $d_{23}$ = 20 nm in die InGaP-Schicht 22, 24 eingebettet. Durch Verwendung einer bromhaltigen Ätzlösung ergibt sich in 0-11 orientiertem InGaP ein Ätzwinkel von $\alpha$ = 54°.

Gemäß Relation (5) ergibt sich für die Dicke der Schicht 24 ein Wert von ca. 35 nm, um die GaAsP-Schicht 23 im Verhältnis 1/4 zu strukturieren. Eine vergleichbare Ätzrate, wie sie für diese Ätzlösung beobachtet wird, ist hierfür Voraussetzung.

Insgesamt ergibt sich nach Fig. 4 ein beispielhafter Schichtenaufbau wie folgt :

- Kontaktschicht 26 aus GaAs
- Obere Mantelschicht 25 aus AlGaAs
- Obere Wellenleiterschicht 24 aus InGaP
- Obere Wellenleiterschicht 23 aus GaAsP
- Obere Wellenleiterschicht 22 InGaP
- Obere Wellenleiterschicht 21 aus AlGaAs
- Aktive Zone 27 aus GaAsP/InGaAsP
- Untere Wellenleiterschicht 28 aus AlGaAs
- Untere Mantelschicht 29 aus AlGaAs
- Substrat 30 aus GaAs

**Bezugszeichenliste**

1    Maskierungsschicht
2    Halbleiterkörper
3    Halbleiterschicht

21    obere Wellenleiterschicht

22    obere Wellenleiterschicht
23    obere Wellenleiterschicht
24    obere Wellenleiterschicht
25    obere Mantelschicht
26    Kontaktschicht
27    Aktive Zone
28    untere Wellenleiterschicht
29    untere Wellenleiterschicht
30    Substrat

d    Schichtdicke
n    Brechungsindex

$\alpha$    Ätzwinkel

**Patentansprüche**

1.  Verfahren zur Herstellung eines Braggschen Gitters in einer Halbleiterschichtenfolge eines Halbleiterkörpers mit einem Tastverhältnis von 1/4 oder 3/4 mittels Ätzen, bei dem in eine kristalline Halbleiterschicht der Schichtenfolge des Halbleiterkörpers, in der das Braggsche Gitter hergestellt werden soll, mindestens eine zusätzliche Halbleiterschicht (23) definierter Dicke ($d_{23}$) als Zwischenschicht mit einem zu den angrenzenden Schichten (22, 24) unterschiedlichen Brechungsindex ($n_{23}$) eingebracht wird, danach das Braggsche Gitter geätzt wird, indem ein auf die Schichtenfolge (24, 23, 22) aufgebrachte Maskierungsschicht (1) mit einem Tastverhältnis von etwa 1/2 strukturiert und die unter der Maskierungsschicht (1) liegenden Schichten (24, 23, 22) bis mindestens einschließlich der zusätzlichen Halbleiterschicht (23) oder zusätzlichen Halbleiterschichten geätzt werden,
    **dadurch gekennzeichnet, dass**
    die zusätzliche eingebrachte Schicht (23) mit einem Winkel $\alpha$, der sich aus dem Ätzprozess und der Kristallorientierung der zu ätzenden Materialien bestimmt, so geätzt wird, dass sich in der zusätzlich eingebrachten Schicht (23) ein gewünschtes Tastverhältnis $\Lambda_1/\Lambda$ von 1/4 oder 3/4 ergibt, wobei die Dicke ($d_{24}$) der über der zusätzlichen Halbleiterschicht (23) liegenden Schicht (24) aus dem gewünschten Tastverhältnis nach_der Beziehung

$$\frac{\Lambda_1}{\Lambda} = \frac{1}{2} + \frac{2\left(d_{24} + \frac{d_{23}}{2}\right)}{\Lambda \tan \alpha}$$

    ermittelt wird, in der die Periode der Brechzahländerung A sich aus der Beziehung

$$\lambda = 2n\Lambda / m$$

    ergibt, in der
    $\lambda$ die Wellenlänge des Lichts ist, $n$ die mittlere Brechzahl des Materials der Schichtenfolge des Halbleiterkörpers und m die Ordnung des Braggschen Gitters,
    und nach Entfernen der Maskierungsschicht (1) abschließend eine Halbleiterschicht (25) mit einem Brechungsindex, welcher den Brechungsindices der die zusätzliche Schicht (23) umgebenden Schichten (24, 22) entspricht, aufgebracht wird.

2.  Verfahren nach Anspruch 1,
    **dadurch gekennzeichnet, dass**
    die Gitterstruktur nass- und/oder trockenchemisch geätzt wird.

3.  Verfahren nach Anspruch 1 oder 2,
    **dadurch gekennzeichnet, dass**
    die zusätzliche Schicht (23) aus einer Halbleiterschichtenfolge besteht.

7

**4.** Halbleiter-Bauelement mit einer Folge von Halbleiterschichten und einem mittels Ätzen und Wiederauffüllen mit Halbleitermaterial hergestellten Braggschen Gitter mit Tastverhältnis von 1/4 oder 3/4, wobei in die kristalline Halbleiterschicht, in der sich das Braggsche Gitter befindet, mindestens eine zusätzliche Halbleiterschicht (23) definierter Dicke ($d_{23}$) und unterschiedlichem Brechungsindex ($n_{23}$) zu den angrenzenden Schichten (22, 24) eingebracht ist,
**dadurch gekennzeichnet, dass**
die Gitterstruktur des Braggschen Gitters mit einem Winkel $\alpha$ bis mindestens einschließlich der zusätzlichen Halbleiterschicht (23) oder zusätzlichen Halbleiterschichten so herausgeätzt ist, dass die zusätzlich eingebrachte Schicht das gewünschte Tastverhältnis $\Lambda_1/\Lambda$ von 1/4 oder 3/4 einnimmt, wobei sich die Dicke ($d_{24}$) der über der zusätzlichen Halbleiterschicht (23) liegenden Schicht (24) aus dem gewünschten Tastverhältnis nach der Beziehung

$$\frac{\Lambda_1}{\Lambda} = \frac{1}{2} + \frac{2\left(d_{24} + \frac{d_{23}}{2}\right)}{\Lambda \tan \alpha}$$

ergibt, in der die Periode der Brechzahländerung aus der Beziehung

$$\lambda = 2n\Lambda / m$$

ermittelt ist, in der
$\lambda$ die Wellenlänge des Lichts ist, $n$ die mittlere Brechzahl des Materials der Schichtenfolge des Halbleiterkörpers und m die Ordnung des Braggschen Gitters.

**5.** Halbleiter-Bauelement nach Anspruch 4,
**dadurch gekennzeichnet, dass**
die Gitterstruktur für kantenemittierende Laser mit verteilter Rückkopplung und/oder Braggscher Reflektoren in oberen Wellenleiterschichten aus AlGaAs (21), InGaP (22), GaAsP (23), InGaP (24) in einem Halbleiterkörper in vertikaler Folge ausgebildet ist .

**Claims**

**1.** Method for the production of a Bragg grating having a duty cycle of 1/4 or 3/4 in a semiconductor layer sequence of a semiconductor body by etching, wherein at least one additional semiconductor layer (23) of a defined thickness ($d_{23}$) is inserted as an intermediate layer having a refractive index ($n_{23}$) that is different from the refractive indexes of the adjacent layers (22, 24) in a crystal semiconductor layer of the layer sequence of the semiconductor body in which the Bragg grating is to be produced, the Bragg grating being subsequently etched by structuring a masking layer (1) applied to the layer sequence (24, 23, 22) to comprise a duty cycle of circa 1/2, and by etching the layers (24, 23, 22) situated beneath the masking layer (1) at least up to and including the additional semiconductor layer (23) or the additional semiconductor layers,
**characterized in that**
the additionally inserted layer (23) is etched to comprise an angle $\alpha$ that results from the etching process and the crystal orientation of the etched material in such a way that a desired duty cycle $\Lambda_1 / \Lambda$ of 1/4 or 3/4 is produced in the additionally inserted layer (23), the thickness ($d_{24}$) of the layer (24) situated above the additional semiconductor layer (23) being determined by the desired duty cycle according to the relation

$$\frac{\Lambda}{\Lambda_1} = \frac{1}{2} + \frac{2\left(d_{24} + \dfrac{d_{23}}{2}\right)}{\Lambda \tan\alpha}$$

where the period of the refractive index change A results from the relation

$$\lambda = 2n\Lambda / m$$

where
λ is the wavelength of the light, *n* being the average refractive index of the material of the layer sequence of the semiconductor body, and *m* being the order of the Bragg grating,
and **in that** after removing the masking layer (1), a semiconductor layer (25) having a refractive index that corresponds to the refractive indexes of the layers (24, 22) that enclose the additional layer (23) is applied in conclusion.

2. The method of claim 1,
**characterized in that**
the grating structure is etched by using a wet chemical and/or a dry chemical etch.

3. The method of claims 1 or 2,
**characterized in that**
the additional layer (23) is composed of a semiconductor layer sequence.

4. A semiconductor device comprising a sequence of semiconductor layers and a Bragg grating having a duty cycle of 1/4 or 3/4, the Bragg grating being produced by etching and by the refilling with semiconductor material, wherein at least one additional semiconductor layer (23) of a defined thickness ($d_{23}$) and having a refractive index ($n_{23}$) that is different from the refractive indexes of the adjacent layers (22, 24) is inserted in the crystal semiconductor layer in which the Bragg grating is situated,
**characterized in that**
the grating structure of the Bragg grating is etched at least up to and including the additional semiconductor layer (23) or the additional semiconductor layers, the grating structure being etched to comprise an angle α in such a way that the additionally inserted layer comprises the desired duty cycle $\Lambda_1 / \Lambda$ of 1/4 or 3/4, the thickness ($d_{24}$) of the layer (24) that is situated above the additional semiconductor layer (23) resulting from the desired duty cycle according to the relation

$$\frac{\Lambda}{\Lambda_1} = \frac{1}{2} + \frac{2\left(d_{24} + \dfrac{d_{23}}{2}\right)}{\Lambda \tan\alpha}$$

where the period of the refractive index change A is determined by the relation

$$\lambda = 2n\Lambda / m$$

where
λ is the wavelength of the light, *n* being the average refractive index of the material of the layer sequence of the semiconductor body, and *m* being the order of the Bragg grating.

5. The semiconductor device of claim 4,
**characterized in that**
in upper waveguide layers of AlGaAs (21), InGaP (22), GaAsP (23), InGaP (24) the grating structure for edge-emitting lasers having a distributed feedback and/or Bragg reflectors is formed in a semiconductor body in vertical sequence.

**Revendications**

1. Procédé de production d'un réseau de Bragg lequel comprend un rapport cyclique de 1/4 ou de 3/4 dans une succession de couches de semi-conducteurs d'un corps semi-conducteur par gravure, dans lequel au moins une couche de semi-conducteur supplémentaire (23) d'une épaisseur définie ($d_{23}$) est insérée dans une couche de semi-conducteur cristalline de la succession des couches du corps semi-conducteur dans laquelle le réseau de Bragg doit être produit, la couche de semi-conducteur supplémentaire (23) y étant insérée comme couche intermédiaire dont l'indice de réfraction ($n_{23}$) est différent de celui des couches adjacentes (22, 24), le réseau de Bragg étant ensuite gravé en structurant une couche de masquage (1) appliquée sur la succession des couches (24, 23, 22) de sorte que la couche de masquage (1) comprenne un rapport cyclique de circa 1/2, les couches (24, 23, 22) situées au-dessous de la couche de masquage (1) étant gravées jusqu'à au moins la couche de semi-conducteur supplémentaire (23) incluse ou les couches de semi-conducteurs supplémentaires incluses,

**caractérisé en ce que**

la couche insérée supplémentairement (23) est gravée afin de comprendre un angle $\alpha$ lequel résulte du processus de gravure et de l'orientation cristalline des matériaux à graver, la couche insérée supplémentairement (23) étant gravée de sorte qu'on obtienne un rapport cyclique souhaité $\Lambda_1 / \Lambda$ de 1/4 ou de 3/4 dans la couche insérée supplémentairement (23), l'épaisseur ($d_{24}$) de la couche (24) située au-dessus de la couche de semi-conducteur supplémentaire (23) étant déterminée par le rapport cyclique souhaité selon la relation

$$\frac{\Lambda}{\Lambda_1} = \frac{1}{2} + \frac{2\left(d_{24} + \dfrac{d_{23}}{2}\right)}{\Lambda \tan\alpha}$$

dans laquelle la période du changement de l'indice de réfraction $\Lambda$ résulte de la relation

$$\lambda = 2n\Lambda / m,$$

dans laquelle

$\lambda$ est la longueur d'onde de la lumière, $n$ étant l'indice de réfraction moyen du matériau de la succession des couches du corps semi-conducteur, et $m$ étant l'ordre du réseau de Bragg,

et **en ce qu'**après l'enlèvement de la couche de masquage (1), une couche de semi-conducteur (25) est appliquée en conclusion dont l'indice de réfraction correspond aux indices de réfraction des couches (24, 22) lesquelles entourent la couche supplémentaire.

2. Procédé selon la revendication 1,
   **caractérisé en ce que**
   la structure de réseau est gravée par voie humide et/ou par voie sèche.

3. Procédé selon la revendication 1 ou 2,
   **caractérisé en ce que**
   la couche supplémentaire (23) se compose d'une succession de couches de semi-conducteurs.

4. Composant à semi-conducteur constitué d'une succession de couches de semi-conducteurs et d'un réseau de Bragg, le réseau de Bragg étant produit par gravure et par le nouveau remplissage de matériau semi-conducteur et comprenant un rapport cyclique de 1/4 ou de 3/4, dans lequel au moins une couche de semi-conducteur supplémentaire (23) d'une épaisseur définie ($d_{23}$) et dont l'indice de réfraction ($n_{23}$) est différent de celui des couches adjacentes (22, 24), est insérée dans la couche de semi-conducteur cristalline dans laquelle se trouve le réseau de Bragg,
   **caractérisé en ce que**
   la structure de réseau du réseau de Bragg est gravée jusqu'à au moins la couche de semi-conducteur supplémentaire (23) incluse ou les couches de semi-conducteurs supplémentaires incluses, la strcuture de réseau étant gravée afin de comprendre un angle $\alpha$ de sorte que la couche insérée supplémentairement comprenne un rapport cyclique souhaité $\Lambda_1 / \Lambda$ de 1/4 ou de 3/4, l'épaisseur ($d_{24}$) de la couche (24) située au-dessus de la couche de semi-conducteur supplémentaire (23) résultant du rapport cyclique souhaité selon la relation

$$\frac{\Lambda}{\Lambda_1} = \frac{1}{2} + \frac{2\left(d_{24} + \dfrac{d_{23}}{2}\right)}{\Lambda \tan\alpha}$$

dans laquelle la période du changement de l'indice de réfraction est déterminée par la relation

$$\lambda = 2n\Lambda / m,$$

dans laquelle
$\lambda$ est la longueur d'onde de la lumière, $n$ étant l'indice de réfraction moyen du matériau de la succession des couches du corps semi-conducteur, et $m$ étant l'ordre du réseau de Bragg.

5. Composant à semi-conducteur selon la revendication 4,
   **caractérisé en ce qu'**
   au cas de lasers à émission par la tranche à rétroaction distribuée et/ou réflecteurs de Bragg la structure de réseau est formée en succession verticale dans un corps semi-conducteur dans des couches de guide d'ondes supérieures d'AlGaAs (21), InGaP (22), GaAsP (23), InGaP (24).

$\Lambda_1 / \Lambda = 3 / 4$

Fig. 1

Fig. 2a

Fig. 2b

Fig. 2c

Fig. 3a

Fig. 3b

Fig. 3c

Fig. 4